# EUROPEAN PATENT SPECIFICATION

(11) **EP 0 488 354 B1**
(45) Date of publication and mention of the grant of the patent: **14.05.1997**
(21) Application number: 91120493.1
(22) Date of filing: 29.11.1991
(51) Int. Cl.: G11C 16/06, G04G 11/00, G04C 10/04

(54) **Data storage apparatus**
Datenspeicheranordnung
Appareil d'emmagasinage de données

(30) Priority: 30.11.1990 JP 334527/90; 30.11.1990 JP 128002/90 U
(43) Date of publication of application: 03.06.1992
(73) Proprietor: CASIO COMPUTER COMPANY LIMITED, Shinjuku-ku Tokyo 160 (JP)
(72) Inventor: Tonegawa, Nobuyuki, c/o Patent Dept.Dev.Div.Hamura, Hamura-shi, Tokyo 190-11 (JP); Yamaguchi, Syuji, c/o Patent Dept.Dev.Div.Hamura, Hamura-shi, Tokyo 190-11 (JP)
(74) Representative: Grünecker, Kinkeldey, Stockmair & Schwanhäusser Anwaltssozietät

(56) References cited:
- EP-A- 0 075 825
- EP-A- 0 124 092
- DE-A- 2 442 394
- US-A- 4 564 922
- PATENT ABSTRACTS OF JAPAN vol. 14, no. 474, 16 October 1990 & JP-A-21 90 715
- PATENT ABSTRACTS OF JAPAN vol. 15, no. 37, 29 January 1991 & JP-A-22 75 506
- PATENT ABSTRACTS OF JAPAN vol. 15, no. 5, 8 January 1991 & JP-A-22 54 320
- PATENT ABSTRACTS OF JAPAN vol. 12, no. 129, 21 April 1988 & JP-A-62 251 912
- PATENT ABSTRACTS OF JAPAN vol. 8, no. 10 (P-248)(1446) 18 January 1984 & JP-A-58 169 395

## Description

The present invention relates to a data storage apparatus for storing various data in a nonvolatile memory such as an EEPROM, by using a battery as a power supply.

From EP-A-0 075 825 a memory protection circuit arrangement and postage meter system for electronic postage meters is known in which inadvertent writing of spurious data into memory locations in a nonvolatile memory during a power down cycle is prevented. The memory protection circuit works in conjunction with a WRITE voltage terminal associated with the nonvolatile memory. A first voltage source providing a predetermined polarity voltage is coupled to the WRITE voltage terminal when a predetermined power condition exists such that the nonvolatile memory is enabled to have data written into memory locations thereof. When the predetermined power condition does not exist, a second different voltage source is utilised to change the voltage level at the WRITE voltage terminal to ensure that data is not written into the memory locations. The postage meter further comprises display means for providing information to the user. There is no information in the document on what is displayed to the user. Power is supplied to the postage meter by an AC line voltage. In case of a failure of the AC power, the accounting module microprocessor included in the postage meter transfers information from the volatile memory to a nonvolatile memory.

From JP-A-2 275 506 it is known to prevent a control program from being erased by including a calculating means for calculating the residual lifetime of a back-up battery and an alarm output means for outputting information relating to the arrival of the battery at its lifetime in a CNC device. This is achieved by a CPU controlling the movement of the whole device, a RAM storing various information including a control program and a calendar timer counting up various lapsed times. Time data obtained by counting the various lapsed times is sent to the CPU, and the residual lifetime of the back-up battery is calculated by the CPU. An alarm is outputted to a CRT display when it is necessary to inform the user of the arrival of the lifetime of the battery to recommend its replacement.

In conventional data storage apparatuses such as an electronic notebook and an electronic wristwatch, various types of data, e.g., name/telephone-number data and schedule data, are stored in a RAM. Power is supplied from a battery to the RAM to preserve the stored contents. When the voltage of the battery is decreased, the exhaustion of the battery is informed to a user. In order to prevent the stored contents from being lost upon replacement of the exhausted battery, for example, a large-capacitance capacitor is connected in parallel with the RAM. With this arrangement, the data stored in the RAM is preserved for a predetermined period of time until the discharge voltage of the capacitor is decreased, thus allowing the user to replace the battery with a new one within the predetermined period of time.

In a conventional data storage apparatus, however, if replacement of a battery is not performed when it is necessary, the data stored in the RAM is lost. For this reason, the use of a nonvolatile memory such as an EEPROM (electrically erasable and programmable read only memory) capable of preserving the stored contents when the power supply is turned off has been proposed.

An EEPROM is designed to perform a write operation at a high voltage. If, therefore, the battery voltage is not sufficiently high, data cannot be properly written. In addition, the EEPROM has a data write count limit. If a write operation is repeatedly performed a number of times exceeding a predetermined number, normally, no more data can be written in the corresponding storage area.

In general, when various data such as name/telephone-number data and schedule data are to be stored in an EEPROM, since data editing is frequently repeated, the data write count is increased. Therefore, when a data write operation with respect to the EEPROM is disabled, the user cannot judge whether the write operation is disabled by the exhaustion of the battery or an excessive data write count.

The present invention has been made to solve the above problems, and has as its object to provide a data storage apparatus which can inform a cause for a disabled data write operation with respect to a nonvolatile memory.

In order to achieve the above object, according to the present invention, there is provided a data storage apparatus comprising a battery power supply, data input means for inputting data, nonvolatile memory means, operated by a power supply voltage from said battery power supply, for storing data input by said data input means, write determination means for determining whether the data is correctly written in said nonvolatile memory means, voltage detecting means for detecting a voltage of said battery power supply when said write determination means determines that the data cannot be correctly written, and informing means for informing, on the basis of a detection result obtained by said voltage detecting means, whether the data cannot be correctly written because of a decrease in voltage of said battery power supply or any other factors.

With this arrangement, according to the present invention, when a data write operation is disabled, the cause for the disabled operation can be informed, i.e., whether it is caused by a decrease in battery voltage or any other factors. Therefore, a user can be urged to replace the battery. In addition, this can prevent the user from stopping the use of a certain storage area by misjudging that the data write count limit is exceeded.

This invention can be more fully understood from the following detailed description when taken in conjunction with the accompanying drawings, in which:
Figs. 1 to 12 show the first embodiment of the present invention, in which:
Fig. 1 is a perspective view of an electronic wristwatch,
Fig. 2 is a perspective view showing the arrangement of a display portion,
Fig. 3 is a block diagram showing the circuit arrangement of the electronic wristwatch,
Fig. 4 is a block diagram showing the circuit arrangement of a battery voltage detecting section,
Fig. 5 is a view showing the memory architecture of a RAM,
Fig. 6 is a view showing the memory architecture of an EEPROM,
Fig. 7 is a flow chart showing the overall operation,
Figs. 8A to 8E are views showing changes in display during a data setting operation,
Fig. 9 is a flow chart showing the process of storing data in the EEPROM, and
Figs. 10A to 12 are views respectively showing display states; and
Figs. 13 to 19 show the second embodiment of the present invention, in which:

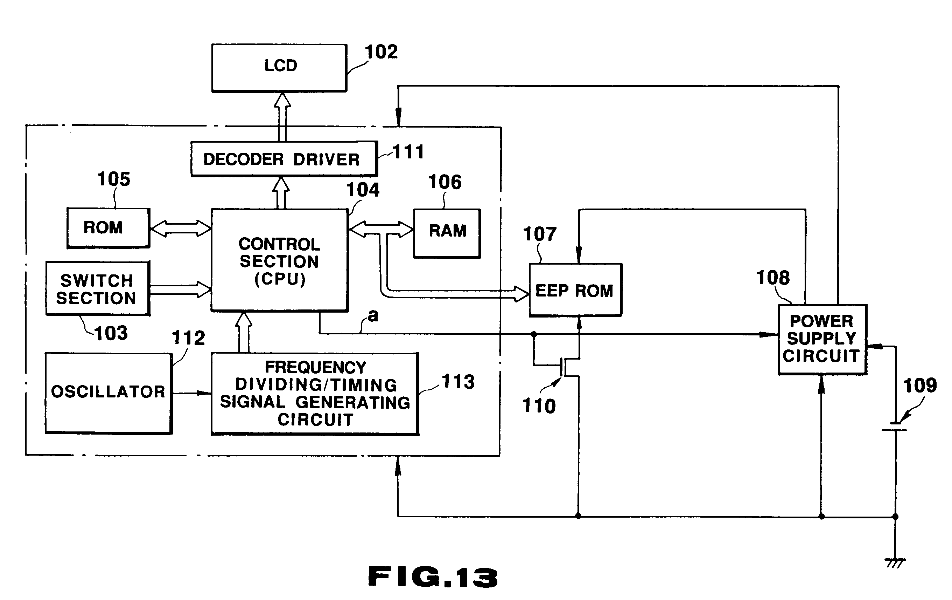

Fig. 13 is a block diagram showing the circuit arrangement of an electronic wristwatch,

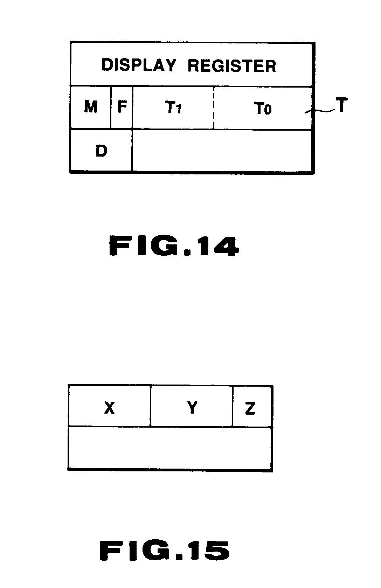

Fig. 14 is a view showing the memory architecture of a RAM 106,
Fig. 15 is a view showing the memory architecture of an EEPROM 107,

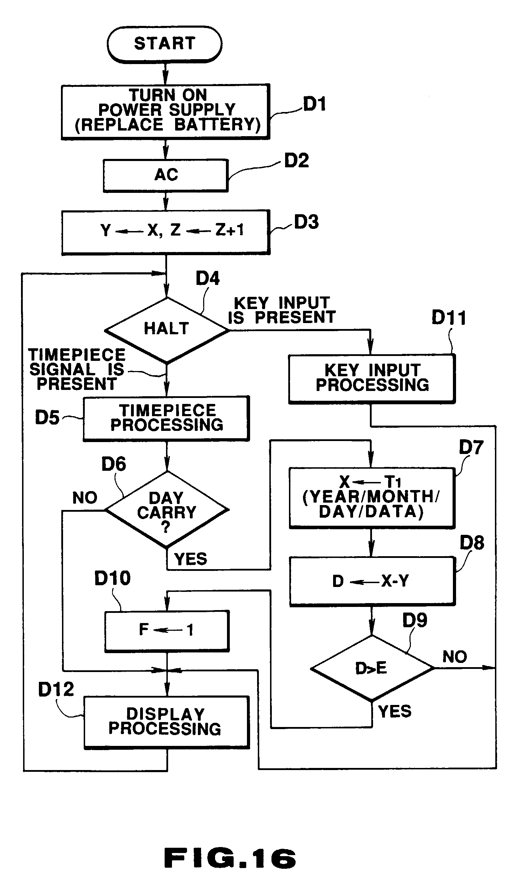

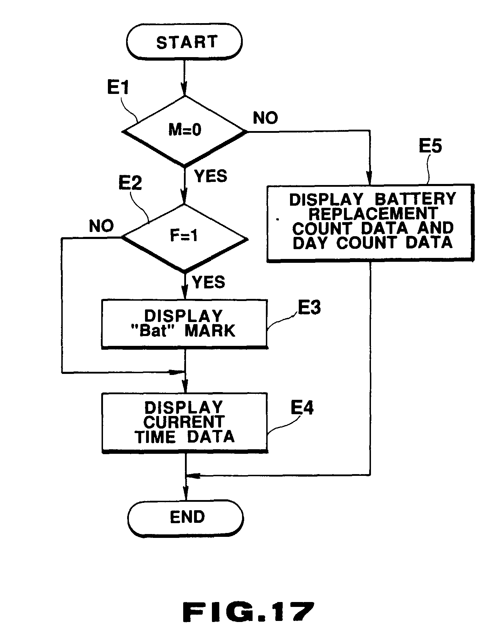

Figs. 16 and 17 are flow charts respectively showing sequences of operations,

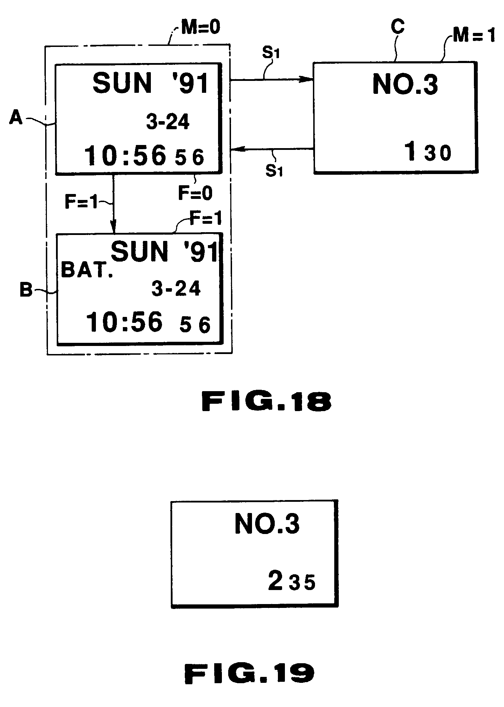

Fig. 18 is a view showing a display state, and
Fig. 19 is a view showing another display state.

### [First Embodiment]

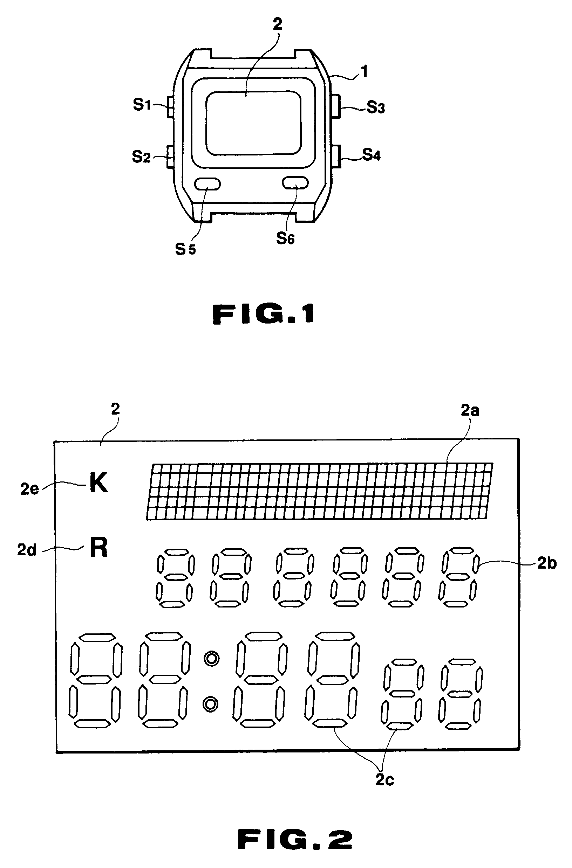

An embodiment of the present invention will be described below with reference to Figs. 1 to 12. In this embodiment, a data storage apparatus of the present invention is applied to an electronic wristwatch.

Fig. 1 is a perspective view of an electronic wristwatch to which the present invention is applied. An LCD (liquid crystal display panel) 2 and S₁ to S₆ keys of a push-button type are arranged on an electronic wristwatch main body 1. The S₁ key is used to invert the content of a mode register M (to be described later). The S₂ key is a key for inverting the content of a flag register F to switch a data display state and a set data display state with each other when "M = 1". The S₃ key serves to perform sequential searches for data stored in a RAM (to be described later) and select a digit position in data correction. The S₄ key is used to perform sequential searches for data stored in an EEPROM (to be described later) and perform character selection for data correction. The S₅ key serves to display a data write count with respect to the EEPROM. The S₆ key is used for other processing.

Fig. 2 shows the arrangement of the LCD 2. The LCD 2 comprises a dot matrix display portion 2a for displaying characters, numeric segment display portions 2b and 2c for displaying numerals, a reservation completion mark ("R" display element) display portion 2d, and a "keep" mark display portion ("K" display element) 2e. The dot matrix display portion 2a displays name data included in name/telephone-number data. The numeric segment display portions 2b and 2c display time data or telephone number data included in the name/telephone-number data. The reservation completion mark (R) display portion 2d indicates that the process of reserving the name/telephone-number data, displayed on the dot matrix display portion 2a and the numeric segment display portions 2b and 2c, in an EEPROM 7 is completed. The "keep" mark display portion (K) 2e indicates that the displayed name/telephone-number data is kept in the EEPROM 7.

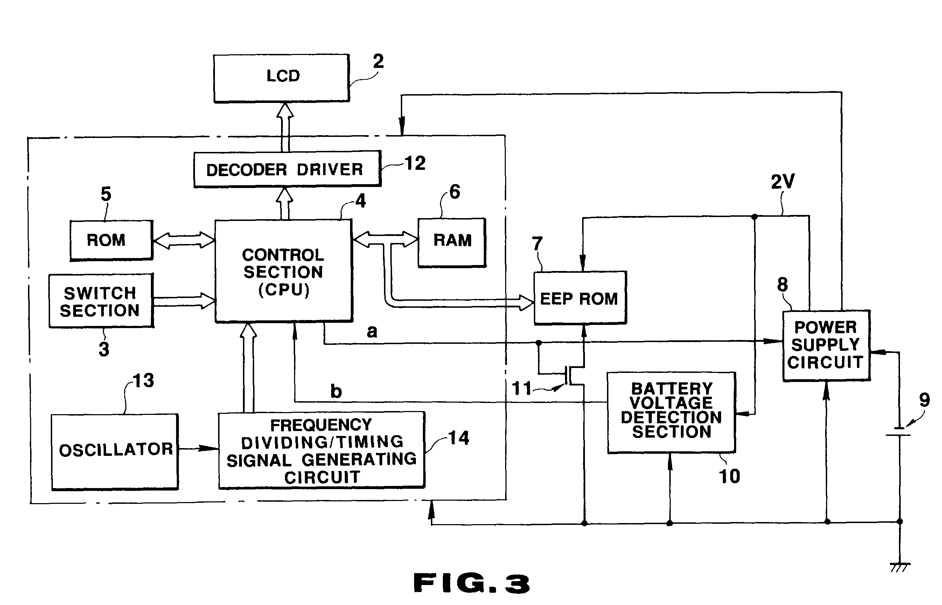

Fig. 3 is a block diagram showing the circuit arrangement of the electronic wristwatch. Referring to Fig. 3, a switch section 3 includes the S₁ to S₆ keys shown in Fig. 1, and serves to output a key input signal corresponding to a key input to a control section 4. The control section 4 (CPU) is a central processing unit for performing various types of processing in accordance with microprograms stored in a ROM 5 in advance. A RAM 6 as a volatile memory serves to store various types of data, e.g., name/telephone-number data. Reference numeral 7 denotes an EEPROM as a nonvolatile memory for storing arbitrarily selected name/telephone-number data. A power supply circuit 8 applies a driving voltage (a rated voltage of 1.5 V) to the respective components in accordance with a voltage (3 V) applied from a lithium battery 9, and also supplies a predetermined voltage of e.g., 2 V to the EEPROM 7 in response to a signal a output from the control section 4.

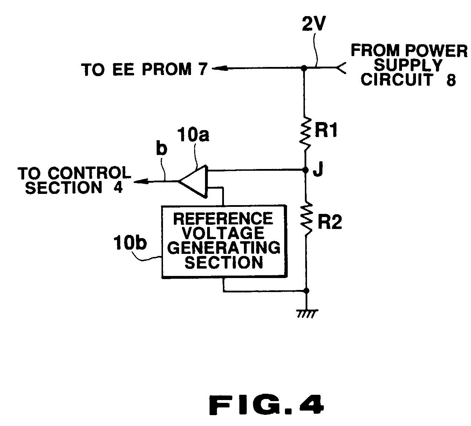

A battery voltage detecting section 10 determines whether the driving voltage output from the power supply circuit 8 is proper, i.e., 2 V or more, and outputs a detection signal b to the control section 4 if the driving voltage is lower than 2 V. The battery voltage detecting section 10 will be described in detail below with reference to Fig. 4. The driving voltage of 2 V output from the power supply circuit 8 is divided into voltages of 1 V by voltage-dividing resistors R1 and R2. A voltage (a rated voltage of 1 V) at a node J between the voltage-dividing resistors R1 and R2 is applied to one input terminal of a comparator 10a. In addition, a reference voltage of, e.g., 1 V is applied from a reference voltage generating section 10b to the other input terminal of the comparator 10a. The comparator 10a compares the voltage at the node J with the reference voltage (1 V). If the voltage at the node J is lower than the reference voltage (1 V), the comparator 10a outputs the detection signal b to the control section 4.

Referring to Fig. 3 again, a MOS transistor 11 is a gate element for controlling the supply of power to the EEPROM 7. More specifically, the MOS transistor 11 is turned on in response to the signal a output from the control section 4 to connect the EEPROM 7 to the ground voltage (GND). A decoder driver 12 outputs a display driving signal, based on display data output from the control section 4, to the LCD 2. An oscillator 13 incorporates a quartz oscillator and serves to output, e.g., a 32-k(32768)Hz clock pulse to a frequency dividing/timing signal generating circuit 14. The frequency dividing/timing signal generating circuit 14 frequency-divides the clock pulse supplied from the oscillator 13 to generate various types of timing signals such as a timepiece signal. The circuit 14 then outputs the timing signals to the control section 4.

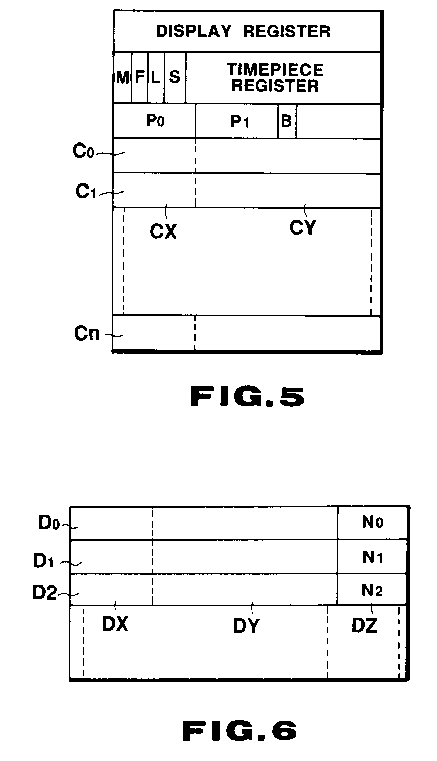

Fig. 5 shows the memory architecture of the RAM 6. As shown in Fig. 5, the RAM 6 includes various types of registers and TEL data memories C₀ to Cₙ for storing name/telephone-number data. A display register is a register for storing data to be displayed on the LCD 2. A mode register M stores mode data. When M = 0 (the value of the register M is "0"), the current time display mode is set. When M = 1 (the value of the register M is "1"), the data display mode is set. A flag register F stores a flag indicating whether data correction is being performed. A flag register L stores a selection flag indicating whether the RAM 6 or the EEPROM 7 is selected in a data read/write operation. When L = 0, the RAM 6 is selected. When L = 1, the EEPROM 7 is selected. A register S is a try counter for counting the number of times that write operations are executed with respect to the EEPROM 7. A timepiece register serves to store current time data (date and time) counted by the control section 4. A register P₀ is a pointer for designating the address of each of the TEL data memories C₀ to Cₙ. A register P₁ is a pointer for designating the address of each of TEL data memories D₀, D₁,... in the EEPROM 7 shown in Fig. 6. A register B stores data indicating a cause for a disabled write operation with respect to the EEPROM 7. If the disabled write operation is caused by a decrease in battery voltage, "B = 1" is set. If the disabled write operation is caused by other factors, e.g., an excessive data write count, "B = 2" is set. In each of the TEL data memories C₀ to Cₙ, alphabetical name data is stored in an area CX, and telephone number data consisting of numerals and a symbol (hyphen) is stored in an area CY.

Fig. 6 shows the memory architecture of the EEPROM 7. As shown in Fig. 6, a large number of TEL data memories D₀, D₁,... are arranged in the EEPROM 7. In each of the TEL data memories D₀, Dₙ,..., alphabetical name data is stored in an area DX, and telephone number data consisting of numerals and a symbol (hyphen) is stored in an area DY. In addition, data write counts N₀, N₁, N₂,... with respect to the TEL data memories D₀, D₁, ... are respectively stored in areas DZ.

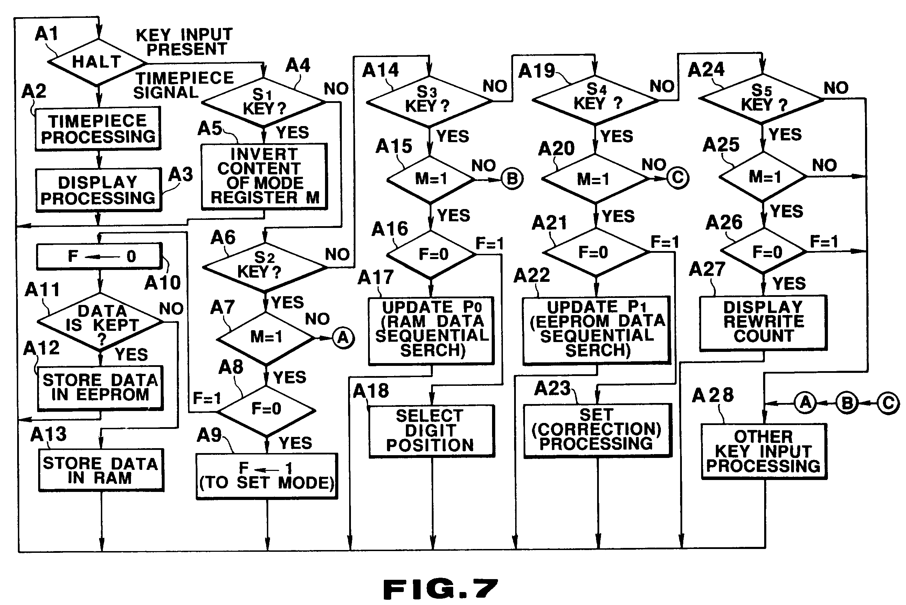

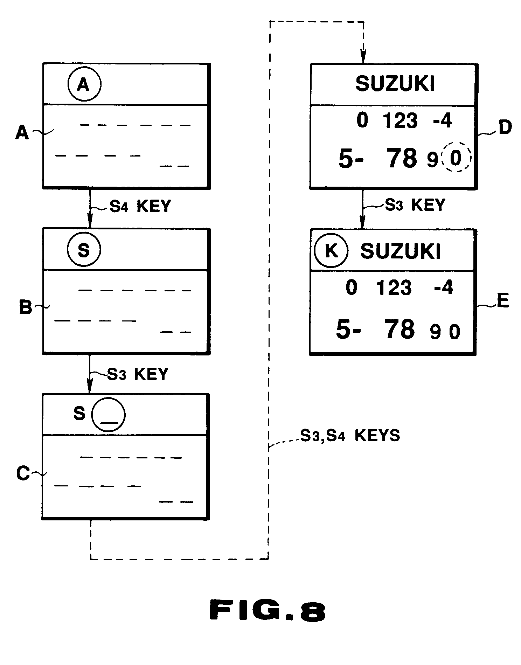

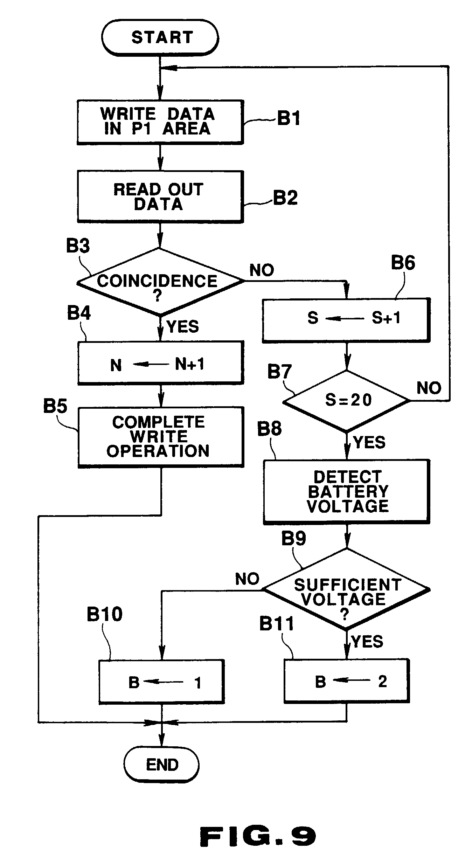

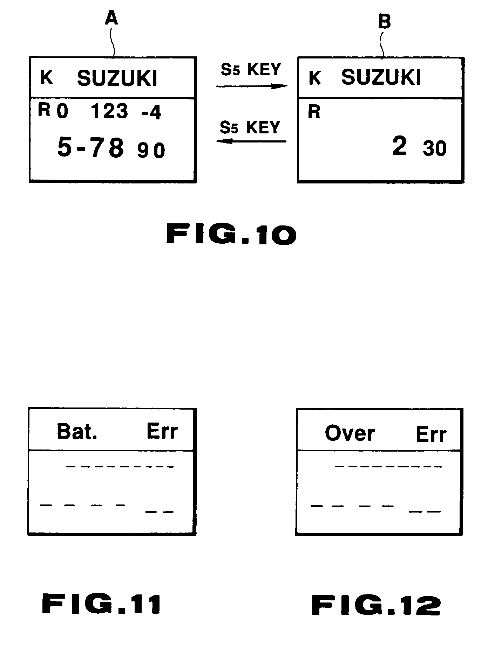

Sequences of operations of the first embodiment will be describe below with reference to Figs. 7 to 12. Fig. 7 is a flow chart showing the overall operation. Fig. 8 shows examples of display in the data set mode. Fig. 9 is a flow chart showing the process of storing data in the EEPROM 7 shown in Fig. 7. Fig. 10 shows an example of display of a data write count. Fig. 11 shows an example of display in a case wherein a write operation is disabled by a decrease in battery voltage. Fig. 12 shows an example of display in a case wherein a data write operation is disabled by an excessive data write count.

The overall operation will be described first with reference to Fig. 7. The control section 4 is kept in a HALT state in step A1 until a timepiece signal is output from the frequency dividing/timing signal generating circuit 14.

When a timepiece signal is output, the presence of the timepiece signal is determined in step A1, and the flow advances to step A2. In step A2, timepiece processing is performed to update the current time data stored in the timepiece register. In step A3, display processing is performed to display current time data, name/telephone-number data, data write count data, or the like on the LCD 2 in accordance with the contents of the mode register M and the flag register F. After step A3 is executed, the flow returns to step A1.

When one of the S₁ to S₆ keys of the switch section 3 is operated, the presence of a key input is determined in step A1, and the flow advances to step A4. In step A4, it is checked whether the operated key is the S₁ key. If the S₁ key is operated, YES is obtained in step A4, and the flow advances to step A5. In step A5, the content of the mode register M is inverted to change the mode. If, for example, the S1 key is operated while "M = 0", "M = 1" is set to set the data display mode. After step A5 is executed, the flow returns to step A1. If the S₁ key is operated while "M = 1" is set, the current time display mode indicated by "M = 0" is set.

If NO in step A4, the flow advances to step A6. In step A6, it is checked whether the operated key is the S₂ key. If the S₂ key is operated, YES is obtained in step A6, and the flow advances to step A7. In step A7, it is checked whether "M = 1" is set, i.e., the content of the mode register M is "1". If YES in step A7, the flow advances to step A8. If NO in step A7, the flow advances to step A28.

If "M = 1" is set, YES is obtained in step A7, and the flow advances to step A8. In step A8, it is checked whether "F = 0" is set, i.e., the content of the flag register F is "0". If YES in step A8, the flow advances to step A9. If NO (F = 1) in step A8, the flow advances to step A10. If "F = 0" is set, YES is obtained in step A8, and the flow advances to step A9. In step A9, "1" is written in the flag register F to set "M = 1, F = 1", thus setting the data set mode. After step A9 is executed, the flow returns to step A1.

If NO (F = 1) in step A8, the flow advances to step A10. In step A10, "0" is written in the flag register F to set "M = 1, F = 0". The flow then advances to step A11. In step A11, it is checked on the basis of the content of the flag register L whether the set data is to be kept in the EEPROM 7. More specifically, if "L = 1" is set, YES is obtained in step A11, and the flow advances to step A12 to perform data storage processing with respect to the EEPROM 7. As a result, the data set in the display register of the RAM 6 is stored in the EEPROM 7. The process of storing data in the EEPROM 7 will be described in detail later with reference to Fig. 9. If "L = 0" is set, NO is obtained in step A11, and the flow advances to step A13 to store the set data in the RAM 6. When step A12 or A13 is executed, the flow returns to step A1.

If NO in step A6, the flow advances to step A14. In step A14, it is checked whether the operated key is the S₃ key.

If the S3 key is operated, YES is obtained in steps A14, and the flow advances to step A15. In step A15, it is checked whether "M = 1" is set. If YES in step A15, the flow advances to step A16. If NO in step A15, the flow advances to step A28. If M = 1, YES is obtained in step A15, and the flow advances to step A16. In step A16, it is checked whether "F = 0" is set. If YES in step A16, the flow advances to step A17. If NO (F = 0) in step A16, the flow advances to step A18.

If "M = 1, F =0" is set, YES is obtained in both steps A15 and A16, and the flow advances to step A17. In step A17, the address stored in the register P₀ is updated to execute sequential search processing with respect to the data stored in the RAM 6. Thereafter, the flow returns to step A1. If "F = 1" is determined in step A16, the data set mode is set, and the flow advances to step A18. In step A18, digit position selection processing is performed, so that a correction digit position in data correction is shifted to the LSB by one digit. After step A18 is executed, the flow returns to step A1.

If NO in step A14, the flow advances to step A19. In step A19, it is checked whether the operated key is the S₄ key. If YES in step A19, the flow advances to step A20. If NO in step A19, the flow advances to step A24.

If the S₄ key is operated, YES is obtained in step A19, and the flow advances to step A20. In step A20, it is checked whether "M = 1" is set. If YES in step A20, the flow advances to step A21. If NO in step A20, the flow advances to step A28. If YES in step A20, the flow advances to A21 to check whether "F = 0" is set. If YES in step A21, the flow advances to step A22. If NO in step A21, the flow advances to step A23.

If "M = 1, F = 0" is set, YES is obtained in both steps A20 and A21, and the flow advances to step A22. In step A22, the address stored in the register P₁ is updated to execute sequential search processing of the data stored in the EEPROM 7. Thereafter, the flow returns to step A1. If "F = 1" is determined in step A21, since the data set mode is set, the flow advances to step A23. In step A23, set (correction) processing is performed to correct a correction target character. After step A23 is executed, the flow returns to step A1.

If NO in step A19, the flow advances to step A24. In step A24, it is checked whether the operated key is the S₅ key. If YES in step A24, the flow advances to step A25. If NO in step A24, the flow advances to step A28.

If the S5 key is operated, YES is obtained in step A24, and the flow advances to step A25. In step A25, it is checked whether "M = 1" is set. If YES in step A25, the flow advances to step A26. If NO in step A25, the flow advances to step A28. If YES in step A25, the flow advances to step A26 to check whether "F = 0" is set. If YES in step A26, the flow advances to step A27. If NO in step A26, the flow advances to step A28.

In this case, if "M =1, F = 0" is set, YES is obtained in both steps A25 and A26, and the flow advances to step A27. In step A27, the data write counts N₀, N₁, N₂,... corresponding to the TEL data memories D₀, D₁,... of the EEPROM 7, in which the display data is stored, are displayed on the LCD 2.

If NO in each of steps A24, A25, and A26, the flow advances to step A28 to perform other key processing. After step A28 is executed, the flow returns to step A1.

The process of setting name/telephone-number data will be described below with reference to Fig. 8. Assume that the S₁ key is operated to set "M = 1" by the processing in step A5, and that the S₂ key is operated to set "F = 1" by the processing in step A9.

With this operation, the data set mode is set, and the character "A" is flickered on the dot matrix display portion 2a of the LCD 2 in the display processing in step A3, as indicated by Fig. 8A.

In this case, if the S₄ key is repeatedly operated, the characters "A", "B", "C".... are sequentially selected in this order, and the character "S" is flickered, as shown in Fig. 8B. When the displayed character "S" is to be set, the S3 key is operated to select the next digit position.

With this operation, as shown in Fig. 8C, the flickered display is shifted to the second digit position of the dot matrix display portion 2a. If the S₃ and S₄ keys are subsequently operated to set character data and numeric data in the same manner as described above, a name "SUZUKI" is displayed on the dot matrix display portion 2a, and a telephone number "0123-45-7890" is displayed on the numeric segment display portions 2b and 2c, while the numeral "0" at the LSB position is flickered, as shown in Fig. 8D. At this time, the name/telephone-number data "SUZUKI 0123-45-7890" displayed on the LCD 2 is stored in the display register of the RAM 6.

If the S₃ key is operated in this state, "1" is written in the flag register L to set "L = 1", and the EEPROM 7 is selected. As a result, as shown in Fig. 8E, the "keep" mark display portion 2e of the LCD 2 is flickered. The flickered "keep" mark "K" indicates that the name/telephone-number data "SUZUKI 0123-45-7890" displayed on the LCD 2 is stored/kept in the EEPROM 7.

If the S₄ key is operated in the state shown in Fig. 8E, the value of the register L is inverted to "0". That is, the S₄ key inverts the content of the register L.

If the S₂ key is operated in the state shown in Fig. 8E, data storage processing with respect to the EEPROM 7 in step A12 is executed. This processing will be described in detail below with reference to Fig. 9. As described above, if the S₂ key is operated in the state of "M = 1, F = 1", the flow advances from step A6 to step A12 through steps A7, A8, A10, and A11.

In step B1, the name/telephone-number data "SUZUKI 0123-45-7890" stored in the display register of the RAM 6 is written in one of the TEL data memories D₀, D₁, D₂,... of the EEPROM 7 which is designated by the register P₁, e.g., the TEL data memory Dₙ.

In step B2, the name/telephone-number data stored in the TEL data memory Dn designated by the register P₁ is read out to check whether the data is properly written.

In step B3, it is checked whether the name/telephone-number data read out from the EEPROM 7 coincides with the name/telephone-number data "SUZUKI 0123-45-7890" stored in the display register. If YES in step B3, it means that the data is properly stored, and the flow advances to step B4. If NO in step B3, the flow advances to step B6. Since the EEPROM 7 is a memory element in which data is less easily written as compared with a RAM, a write operation must be repeated several times.

For this reason, initially, the name/telephone-number data read out from the EEPROM 7 does not coincide with the name/telephone-number data stored in the display register at first, and NO is obtained in step B3. Hence, the flow advances to step B6. In step B6, the content of the register S is incremented by one to count the number of data write operations. In step B7, it is checked whether the content of the register S is "20" or more. If YES in step B7, the flow advances to step B8. If NO in step B7, the flow returns to step B1, and the processing in steps B1 to B3, B6, and B7 is repeatedly executed.

If the write operation with respect to the EEPROM 7 is repeated several times in this manner, and the data is properly written, YES is obtained in step B3, and the flow advances to step B4. In step B4, a stored value N of the data write count storage area DZ of the TEL data memory Dₙ designated by the register P1 is incremented by one. In step B5, the reservation completion mark (R) display portion 2d of the LCD 2 is driven to indicate that the write operation of the displayed name/telephone-number data with respect to the EEPROM 7 is completed. After step B5 is executed, the processing in Fig. 9 is ended, and the flow returns to step A1. As a result, in the display processing in step A3, the name/telephone-number data "SUZUKI 0123-45-7890" is displayed on the LCD 2 together with the "keep" mark "K" and the reservation completion mark "R", as shown in Fig. 10A.

The content of the data write count storage area DZ is displayed upon operation of the S₅ key. If the S₅ key is operated in the display state shown in Fig. 10A, YES is obtained in steps A24, A25, and A26, and the flow advances to step A27. In step A27, as shown in Fig. 10B, the data write count, e.g., "230", stored in the area DZ of the TEL data memory of the EEPROM 7, in which the displayed name/telephone-number data "SUZUKI 0123-45-7890" is stored, is displayed on the LCD 2 together with the name data "SUZUKI".

Referring to Fig. 9 again, if the processing in steps B1 to B3, B6, and B7 is executed 20 times, and the content of the register S becomes "20", YES is obtained in step B7, and the flow advances to step B8. In step B8, since the data cannot be properly written in the EEPROM 7 after the write operation is repeated 20 times, battery voltage detection processing is performed to detect the voltage of the lithium battery 9. More specifically, the battery voltage detecting section 10 outputs the detection signal b when a driving voltage for the EEPROM 7, which is output from the power supply circuit 8 in accordance with the voltage of the lithium battery 9, is decreased below the rated voltage of 2 V. In step B9, it is checked whether the voltage of the lithium battery 9 is sufficiently high, i.e., the detection signal b is output.

If the detection signal b is output, it means that the voltage of the lithium battery 9 is not sufficiently high, and NO is obtained in step B9. The flow then advances to step B10. In step B10, data "1" is written in the register B to indicate that the cause for the disabled write operation with respect to the EEPROM 7 is a decrease in voltage of the lithium battery 9. After step B10 is executed, the processing in Fig. 9 is ended, and the flow returns to step A1. As a result, in the display processing in step A3, a message "Bat. Err" indicating a disabled write operation due to a decreases in voltage is displayed on the dot matrix display portion 2a of the LCD 2, as shown in Fig. 11. With this message display, the user can know that the battery has been consumed.

If the detection signal b is not output, it means that the voltage of the lithium battery 9 is sufficiently high. Hence, YES is obtained in step B9, and the flow advances to step B11. In step B11, data "2" is written in the register B to indicate that the disabled write operation with respect to the EEPROM 7 is caused by an excessive data write count. After step B11 is executed, the processing in Fig. 9 is ended, and the flow returns to step A1. As a result, in the display processing in step A3, a message "Over Err" indicating a disabled write operation due to an excessive data write count is displayed on the dot matrix display portion 2a of the LCD 2, as shown in Fig. 12. With this message display, the user can know that the data write count limit of a given area of the EEPROM 7 is exceeded.

Although the process of storing data in the RAM 6 in step A13 in Fig. 7 is not described in detail in the above embodiment, it should be noted that input data are sequentially stored in areas in which no data are stored. Data to be stored in the RAM 6 and the EEPROM 7 are not limited to name/telephone-number data, but schedule data, address data, memo data, and the like may be stored. In addition, data to be stored are not limited to key-input data, but input data transferred by data communication or data input by radio or the like may be stored.

### [Second Embodiment]

Figs. 13 to 19 show the second embodiment of the present invention. In the first embodiment described above, a power supply voltage is directly detected by using the comparator 10a. In the second embodiment, however, the remaining service life of a battery is determined on the basis of the number of days which have elapsed since the last battery replacement.

Fig. 13 is a block diagram showing the circuit arrangement of an electronic wristwatch to which the second embodiment is applied. Referring to Fig. 13, a switch section 103 includes S₁ to S₆ keys and serves to output a key input signal corresponding to a key input to a control section 104. The control section (CPU) 104 is a central processing unit for performing various types of processing on the basis of microprograms stored in a ROM 105 in advance. Note that day count data E corresponding to a battery service life (e.g., if a battery service life is 365 days, 335 days are set as the day count data E to inform the need of battery replacement 30 days before the end of the service life) is stored in the ROM 105 in advance in addition to the microprograms.

A RAM 106 as a volatile memory serves to store various types of data and has various types of registers, as shown in Fig. 14. Referring to Fig. 14, a display register is a register for storing display data to be displayed on an LCD 102. A mode register M stores mode data. A flag register F stores a battery service life flag indicating that the end of a battery service life is detected. A register T stores current time data and is constituted by registers T₁ and T₀. The register T₁ stores year/month/day data of the current time data. The register T₀ stores hour/minute/second data of the current time data. A register D stores data count data based on the number of days which have elapsed since the last battery replacement.

Referring to Fig. 13, an EEPROM (electrically erasable and programmable read only memory) 107 is a nonvolatile memory capable of preserving stored contents when the power supply is turned off, allowing rewrite operations. As shown in Fig. 15, the EEPROM 107 comprises a register X for storing current date data, a register Y for storing battery replacement date data, a register Z for storing battery replacement count data, and the like.

Referring to Fig. 13 again, a power supply circuit 108 applies a driving voltage (1.5 V) to the respective components in accordance with a voltage (3 V) applied from a lithium battery 109, and also applies a predetermined driving voltage (2 V) to the EEPROM 107. A MOS transistor 110 is a gate element for controlling the supply of power to the EEPROM 107. More specifically, the MOS transistor 110 is turned on in response to a signal a output from the control section 104 to connect the EEPROM 107 to the ground voltage (GND).

A decoder driver 111 outputs a display driving signal, based on display data output from the control section 104, to the LCD 102. An oscillator 112 incorporates a quartz oscillator and outputs, e.g., a 32-k(32768)Hz clock pulse to a frequency dividing/timing signal generating circuit 113. The frequency dividing/timing signal generating circuit 113 frequency-divides the clock pulse supplied from the oscillator 112 to generate various types of timing signals such as a timepiece signal. The circuit 113 then outputs the timing signals to the control section 104.

An operation of the second embodiment will be described below with reference to Figs. 16 to 18. Fig. 16 is a flow chart showing the overall operation. Fig. 17 is a flow chart showing a sequence of operations in display processing in Fig. 16.

The overall operation will be described first with reference to Fig. 16.

When the lithium battery 109 is replaced, step D1 is executed to turn on the power supply, thus supplying power to the respective components. When an initialization switch (not shown) in a battery case is operated by a user, the flow advances to step D2. In step D2, an AC (all clear) signal is output to initialize the respective circuits such as the RAM 106 except for the EEPROM 107. The AC signal may be automatically output when a battery is replaced. In step D3, the current date data (to be described later) stored in the register X of the EEPROM 107 is written in the register Y to update the battery replacement date data, and the battery replacement count data stored in the register Z is incremented by one. Note that the processing in step D3 is to be executed only once regardless of the number of times that the initialization switch is operated within a predetermined period of time. That is, the processing in steps D1 to D3 is executed only once at the time of battery replacement but is not executed after the battery replacement. After step D3 is executed, the flow advances to step A4.

The control section 104 is normally kept in a HALT state in step D4 until a timepiece signal is output from the frequency dividing/timing signal generating circuit 113. When a timepiece signal is output, the presence of the timepiece signal is determined in step D4, and the flow advances to step D5. In step D5, timepiece processing is performed to update the current time data stored in the register T. In step D6, it is checked whether a date carry is present in the timepiece processing, i.e., the date data of the current time data (year/month/day and hour/minute/second data) is updated. If YES in step D6, the flow advances to step D7. If NO in step D6, the flow advances to step D12.

If a date carry is present, the flow advances from step D6 to step D7. In step D7, the year/month/day data of the current time data stored in the register T₁ is written in the register X of the EEPROM 107, thus updating the current date data in the register X. In step D8, "X (date) - Y (date)" is calculated, i.e., the battery replacement date data in the register Y is subtracted from the current date data in the register X, thus calculating day count data (elapsed day count data) based on the number of days between the two dates, i.e., the number of days which have elapsed since the last battery replacement. The calculated day count data, e.g., "130 (days)" is then written in the register D of the RAM 106. In step D9, it is checked whether D > E, i.e., the day count data "130 (days)" stored in the register D exceeds the battery service life data stored in the ROM 105 in advance. If, for example, the battery service life is "365 days", "335 days" are set as the battery service life data E to detect the end of the batter service life 30 days before the actual end of the battery service life. If YES in step D9, i.e., it is determined that the battery service life has come to an end, the flow advances to step D10. If NO in step D9, the flow advances to step D12. In step D10, "1" is written in the flag register F to set/store the battery service life display flag. The flow then advances from step D10 to step D12.

The display processing will be described in detail below with reference to Fig. 17. In step E1, it is checked whether "M = 0" is set, i.e., the content of the mode register M is "0". If YES in step E1, the flow advances to step E2. If NO in step E1, the flow advances to step E5.

If M = 0, YES is obtained in step E1, and the flow advances to step E2. In step E2, it is checked whether "F = 1" is set, i.e., the content of the flag register F is "1". If YES in step E2, the flow advances to step E3. If NO in step E2, the flow advances to step E4.

If the end of the battery service life is not detected, F is 0, and NO is obtained in step E2. As a result, the flow advances to step E4. In step E4, as indicated by "A" in Fig. 18, current time data "SUN ²91 3-24 10 : 56 56" stored in the register T is displayed on the LCD 102.

If step D10 is executed, and "F = 1" is set, since the end of the battery service life is detected, YES is obtained in step E2, and the flow advances to step E3. In step E3, as indicated by "B" in Fig. 18, "BAT." mark is displayed on the LCD 2. The flow then advances from step E3 to step E4 to display the current time data "SUN ²91 3-24 10 : 56 56" and the "BAT." mark on the LCD 102, as indicated by "B" in Fig. 18. Upon execution of step E4, the display processing in Fig. 17 is completed, and the flow returns to step D4.

If the S₁ key is operated in the display state indicated by "A" in Fig. 18, the presence of a key input is determined in step D4, and the flow advances to step D11. In step D11, since the S1 key is operated, the content of the mode register M is inverted to set "M = 1". The flow then advances from step D11 to step D12 to perform display processing. In this case, since "M = 1" is set, NO is obtained in step E1, and the flow advances to step E5. In step E5, the battery replacement count data, e.g., "No. 3", stored in the register Z of the EEPROM 107 and the day count data, e.g., "130 (days)", stored in the register Z are displayed on the LCD 102, as indicated by "C" in Fig. 18.

With this operation, the user can know that the battery replacement count is three, and the number of days (elapsed day count) which have elapsed since the last battery replacement is 130.

Although the day count "130" is displayed in the above embodiment, the number of remaining days of the battery service life may be displayed. In this case, the day count data "130" is subtracted from the battery service life data "365" to obtain remaining day count data "235" during which the battery can be used. In the display processing, as shown in Fig. 19, the battery replacement count data "No. 3" and the remaining day count data "235" may be displayed on the LCD 102.

In the above embodiment, the need of battery replacement is determined, and the current time is written in the nonvolatile memory in accordance with switching operations. However, the present invention is not limited to this. For example, a detecting unit for detecting a battery voltage may be arranged so that when the battery voltage is decreased below a predetermined voltage, the current time is automatically written, as battery replacement date data, in the nonvolatile memory.

As has been described in detail above, according to this embodiment, when a battery is replaced, the date of battery replacement is stored, as battery replacement date data, in the nonvolatile memory. The end of the battery service life is detected and informed on the basis of this battery replacement date data. Therefore, when the battery voltage is temporarily decreased due to a low temperature or the like, a user does not erroneously determine that the battery service life has come to an end. That is, the user can properly determine the end of a battery service life. In addition, since a battery replacement count is displayed, the user can know how long the watch has been used.

## Claims

1. A data storage apparatus comprising:
a battery power supply (9, 109);
data input means (3, 4, 103, 104) for inputting data;
nonvolatile memory means (7, 107), operated by a power supply voltage from said battery power supply (9, 109), for storing data input by said data input means (3, 4, 103, 104);
write determination means (4, 104) for determining whether the data is correctly written in said nonvolatile memory means (7, 107);
voltage detecting means (10, 4) for detecting a voltage of said battery power supply when said write determination means (4, 104) determines that the data cannot be correctly written; and
informing means (2, 4, 12) for informing, on the basis of a detection result obtained by said voltage detecting means (4, 10), whether the data cannot be correctly written because of a decrease in voltage of said battery power supply or any other factors.

2. An apparatus according to claim 1, characterized in that said nonvolatile memory means comprises an EEPROM (7).

3. An apparatus according to claim 1, characterized by further comprising display means (2, 4, 12) for sequentially displaying data stored in said nonvolatile memory means.

4. An apparatus according to claim 1, characterized by further comprising indication means (2, 4, 12) for indicating that said write determination means (4) determines that the data is correctly written in said nonvolatile memory means (7).

5. An apparatus according to claim 1, characterized by further comprising count means (4, DZ) for counting the number of times that data is stored in said nonvolatile memory means (7), and storage operation count display means (2, 4, 12) for displaying the storage operation count obtained by said count means (4, DZ).

6. An apparatus according to claim 1, characterized by further comprising a timepiece circuit (4, 13, 14) for obtaining time information by counting reference signals, and time display means (2, 4, 12) for displaying the time information obtained by said timepiece circuit (4, 13, 14).

7. An apparatus according to claim 1, characterized in that said data storage apparatus is incorporated in a case of a watch type device worn on a wrist of a

8. A data storage apparatus according to claim 1, further comprising:
date count means (104, 112, 113) for obtaining current date data by counting reference signals;
date storage control means (104) for causing said nonvolatile memory means (107) to store the date data obtained by said date count means (104, 112, 113) when said battery power supply (109) is replaced;
battery service life calculating means (104) for obtaining battery service life data on the basis of the date data stored in said nonvolatile memory means (107) by said date storage control means (104, 112, 113) and the current date data obtained by said date count means (104, 112, 113); and
display means (102, 104, 111) for displaying the battery service life data obtained by said battery service life calculating means (104).

9. An apparatus according to claim 8, characterized in that said nonvolatile memory means includes an EEPROM (107).

10. An apparatus according to claim 8, characterized in that the battery service life data obtained by said battery service life calculating means (104) is the number of days which have elapsed since the last battery replacement.

11. An apparatus according to claim 8, characterized in that the battery service life data obtained by said battery service life calculating means (104) is the number of remaining days up to the next battery replacement.

12. An apparatus according to claim 8, characterized by further comprising indication means for indicating that said write determination means (4, 104) determines that the data is correctly written in said nonvolatile memory means (7).

13. An apparatus according to claim 8, characterized by further comprising count means (Z) for counting the number of times that battery replacement is performed, and a battery replacement count display means (102, 104, 111) for displaying the number of times counted by said count means (Z).

14. An apparatus according to claim 8, characterized by further comprising a timepiece circuit (104, 112, 113) for obtaining time information by counting reference signals, and time display means (102, 104, 111) for displaying the time information obtained by said timepiece circuit (104, 112, 113).

15. An apparatus according to claim 8, characterized in that said data storage apparatus is incorporated in a case of a watch type device worn on a wrist of a user.

16. A data storage apparatus according to claim 1 or 7, further comprising:
volatile memory means (6) for storing the data input by said data input means (3, 4, 103, 104);
selection switch means (L, S3, 4) for selecting one of said volatile memory means (6) and said nonvolatile memory means (7) in which the data input by said data input means (3, 4) is stored; and
storage control means (4) for causing said nonvolatile memory means (7) to store the data input by said data input means (3, 4, 103, 104) when said nonvolatile memory means (7) is selected by said selection switch means (L, S3, 4).

17. An apparatus according to claim 16, characterized in that said volatile memory means includes a RAM (6).

18. An apparatus according to claim 16, characterized in that said informing means (2, 4, 12) comprises first display means for sequentially displaying data stored in said volatile memory means (6), and second display means for sequentially display data stored in said nonvolatile memory means (7).

19. An apparatus according to claim 16, characterized by further comprising a power supply circuit (8) for respectively applying different driving voltages to said volatile memory means (6) and said nonvolatile memory means (7) on the basis of an output voltage from said battery power supply (9).

20. An apparatus according to claim 16, characterized by further comprising count means (DZ) for counting the number of times that the data is stored in said nonvolatile memory means (7), and in that said informing means (2, 4, 12) displays the storage operation count obtained by said count means (DZ).

21. An apparatus according to claim 16, characterized by further comprising a timepiece circuit (4, 13, 14) for obtaining time information by counting reference signals, and in that said informing means (2, 4, 12) displays the time information obtained by said timepiece circuit (4, 13, 14).

## Patentansprüche

1. Datenspeicheranordnung, enthaltend:
eine Batteriespannungsquelle (9, 109);
eine Dateneingabeeinrichtung (3, 4, 103, 104) für die Eingabe von Daten;
eine Permanentspeichereinrichtung (7, 107), die mit einer Spannung aus der Batteriespannungsquelle (9, 109) betrieben wird, um Daten zu speichern, die mit der Dateneingabevorrichtung (3, 4, 103, 104) eingegeben werden;
eine Schreibprüfeinrichtung (4, 104), um zu prüfen, ob die Daten korrekt in den Permanentspeicher (7, 107) geschrieben werden;
eine Spannungserfassungseinrichtung (10, 4) zum Erfassen einer Spannung aus der Batteriespannungsquelle, wenn die Schreibprüfeinrichtung (4, 104) feststellt, daß die Daten nicht korrekt geschrieben werden können; und
eine Informationseinrichtung (2, 4, 12), die auf der Basis eines Prüfergebnisses, das man mit der Spannungserfassungseinrichtung erhält (4, 10), Auskunft darüber gibt, ob aufgrund einer Verminderung der Spannung aus der Batteriespannungsquelle oder aus anderen Gründen die Daten nicht korrekt geschrieben werden können.

2. Anordnung nach Anspruch 1, dadurch gekennzeichnet, daß die Permanentspeichereinrichtung ein EEPROM (7) enthält.

3. Anordnung nach Anspruch 1, durch gekennzeichnet, daß sie weiterhin eine Anzeigeeinrichtung (2, 4, 12) enthält, um nacheinander Daten anzuzeigen, die im Permanentspeicher gespeichert sind.

4. Anordnung nach Anspruch 1, dadurch gekennzeichnet, daß sie weiterhin eine Meldeeinrichtung (2, 4, 12) enthält, um anzuzeigen daß die Schreibprüfeinrichtung (4) feststellt, daß die Daten korrekt in den Permanentspeicher (7) geschrieben werden.

5. Anordnung nach Anspruch 1, dadurch gekennzeichnet, daß sie weiterhin eine Zähleinrichtung (4, DZ) enthält, um zu erfassen, wie oft Daten im Permanentspeicher (7) gespeichert werden, und eine Speichertätigkeits-Zählanzeigeeinrichtung (2, 4, 12), um die Anzahl der Speichertätigkeit anzuzeigen, die man mit der Zähleinrichtung (4, DZ) erhält.

6. Anordnung nach Anspruch 1, dadurch gekennzeichnet, daß sie weiterhin eine Zeituhrschaltung (4, 13, 14) enthält, damit man durch Zählen von Referenzsignalen eine Zeitinformation erhält, und eine Zeitanzeigeeinrichtung (2, 4, 12) zum Anzeigen der Zeitinformation, die man mit der Zeituhrschaltung (4, 13, 14) erhält.

7. Anordnung nach Anspruch 1, dadurch gekennzeichnet, daß die Datenspeicheranordnung in einem Gehäuse in Form einer Armbanduhr untergebracht ist, die vom Benutzer am Handgelenk getragen wird.

8. Datenspeicheranordnung nach Anspruch 1, weiterhin enthaltend:
eine Datumszähleinrichtung (104, 112, 113), mit der man laufende Datumsdaten durch Zählen von Referenzsignalen erhält;
eine Datumsspeicher-Steuereinrichtung (104), um zu bewirken, daß im Permanentspeicher (107) die Datumsdaten gespeichert werden, die man mit der Datumszähleinrichtung (104, 112, 113) erhält, wenn die Batteriespannungsquelle (109) ausgetauscht wird;
eine Batterielebensdauer-Berechnungseinrichtung (104), mit der man Batterielebensdauerdaten auf der Basis der Datumsdaten, die im Permanentspeicher (107) mit der Datumsspeicher-Steuereinrichtung (104, 112, 113) gespeichert sind, und die laufenden Datumsdaten erhält, die von der Datumszähleinrichtung (104, 112, 113) geliefert werden; und
eine Anzeigeeinrichtung (102, 104, 111) für das Anzeigen der Batterielebensdauerdaten, die man mit der Batterielebensdauer-Berechnungseinrichtung (104) erhält.

9. Anordnung nach Anspruch 8, dadurch gekennzeichnet, daß die Permanentspeichereinrichtung ein EEPROM (107) enthält.

10. Anordnung nach Anspruch 8, dadurch gekennzeichnet, daß die Batterielebensdauerdaten, die man mit der Batterielebensdauer-Berechnungseinrichtung (104) erhält, die Anzahl von Tagen sind, die vergangen sind, seitdem die Batterie zum letzten Mal gewechselt wurde.

11. Anordnung nach Anspruch 8, dadurch gekennzeichnet, daß die Batterielebensdauerdaten, die man mit der Batterielebensdauer-Berechnungseinrichtung (104) erhält, die Anzahl der verbleibenden Tage bis zum nächsten Batteriewechsel sind.

12. Anordnung nach Anspruch 8, dadurch gekennzeichnet, daß sie weiterhin eine Meldeeinrichtung enthält, um anzuzeigen, daß die Schreibprüfeinrichtung (4, 104) ermittelt hat, daß die Daten korrekt in den Permanentspeicher (7) geschrieben sind.

13. Anordnung nach Anspruch 8, dadurch gekennzeichnet, daß sie weiterhin eine Zähleinrichtung (Z) enthält, um anzuzeigen, wie oft ein Batteriewechsel durchgeführt wurde, und eine Batteriewechsel-Zählanzeigeeinrichtung (102, 104, 111), um die Anzahl anzuzeigen, die mit der Zähleinrichtung (Z) gezählt wird.

14. Anordnung nach Anspruch 8, dadurch gekennzeichnet, daß sie weiterhin eine Zeituhrschaltung (104, 112, 113) enthält, mit der man eine Zeitinformation durch Zählen von Referenzsignalen erhält, und eine Zeitanzeigeeinrichtung (102, 104, 111) für das Anzeigen der Zeitinformation, die man mit der Zeituhrschaltung (104, 112, 113) erhält.

15. Anordnung nach Anspruch 8, dadurch gekennzeichnet, daß die Datenspeicheranordnung in einem Gehäuse in Form einer Armbanduhr untergebracht ist, die vom Benutzer am Handgelenk getragen wird.

16. Datenspeicheranordnung nach Anspruch 1 oder 7, weiterhin enthaltend:
einen flüchtigen Speicher (6) für das Speichern der Dateneingabe durch die Dateneingabeeinrichtung (3, 4, 103, 104);
einen Wahlschalter (L, S3, 4) für das Auswählen des flüchtigen Speichers (6) oder des Permanentspeichers (7), in dem die Dateneingabe mit der Dateneingabeeinrichtung (3, 4) gespeichert ist; und
eine Speichersteuereinrichtung (4), um zu bewirken, daß im Permanentspeicher (7) die Dateneingabe mit der Dateneingabeeinrichtung (3, 4, 103, 104) gespeichert wird, wenn der Permanentspeicher (7) mit dem Wahlschalter (L, S3, 4) ausgewählt ist.

17. Anordnung nach Anspruch 16, dadurch gekennzeichnet, daß der flüchtige Speicher einen RAM (6) enthält.

18. Anordnung nach Anspruch 16, dadurch gekennzeichnet, daß die Informationseinrichtung (2, 4, 12) eine erste Anzeigeeinrichtung enthält, um nacheinander Daten anzuzeigen, die im flüchtigen Speicher (6) gespeichert sind, und eine zweite Anzeigeeinrichtung, um nacheinander Daten anzuzeigen, die im Permanentspeicher (7) gespeichert sind.

19. Anordnung nach Anspruch 16, dadurch gekennzeichnet, daß sie weiterhin eine Spannungsversorgungsschaltung (8) enthält, um jeweils verschiedene Steuerspannungen an den flüchtigen Speicher (6) und den Permanentspeicher (7) auf der Basis einer Ausgangsspannung aus der Batteriespannungsquelle (9) anzulegen.

20. Anordnung nach Anspruch 16, dadurch gekennzeichnet, daß sie weiterhin eine Zähleinrichtung (DZ) enthält, um zu zählen, wie oft die Daten im Permanentspeicher (7) gespeichert werden, und dadurch, daß die Informationseinrichtung (2, 4, 12) die Zahl der Speichertätigkeit anzeigt, die man mit der Zähleinrichtung (DZ) erhält.

21. Anordnung nach Anspruch 16, dadurch gekennzeichnet, daß sie weiterhin eine Zeituhrschaltung (4, 13, 14) enthält, mit der man die Zeitinformation durch Zählen von Referenzsignalen erhält, und dadurch, daß die Informationseinrichtung (2, 4, 12) die Zeitinformation anzeigt, die man mit der Zeituhrschaltung (4, 13, 14) erhält.

## Revendications

1. Appareil de stockage de données comprenant :
une alimentation par pile (9, 109) ;
un moyen d'entrée de données (3, 4, 103, 104) pour entrer des données ;
un moyen de mémoire non volatile (7, 107), activé par une tension d'alimentation provenant dudit moyen d'alimentation par pile (9, 109), pour stocker des données entrées par ledit moyen d'entrée de données (3, 4, 103, 104) ;
un moyen de détermination d'écriture (4, 104) pour déterminer si les données sont écrites correctement dans ledit moyen de mémoire non volatile (7, 107) ;
un moyen de détection de tension (10, 4) pour détecter une tension de ladite alimentation par pile lorsque ledit moyen de détermination d'écriture (4, 104) détermine que les données ne peuvent pas être écrites correctement ; et
un moyen d'information (2, 4, 12) pour informer, sur la base d'un résultat de détection obtenu par ledit moyen de détection de tension (4, 10), du fait que les données ne peuvent pas être écrites correctement du fait d'une diminution de la tension de ladite alimentation par pile ou du fait de quelconques autres facteurs.

2. Appareil selon la revendication 1, caractérisé en ce que ledit moyen de mémoire non volatile comprend une EEPROM (7).

3. Appareil selon la revendication 1, caractérisé en ce qu'il comprend en outre un moyen d'affichage (2, 4, 12) pour afficher séquentiellement des données stockées dans ledit moyen de mémoire non volatile.

4. Appareil selon la revendication 1, caractérisé en ce qu'il comprend en outre un moyen d'indication (2, 4, 12) pour indiquer que ledit moyen de détermination d'écriture (4) détermine que les données sont écrites correctement dans ledit moyen de mémoire non volatile (7).

5. Appareil selon la revendication 1, caractérisé en ce qu'il comprend en outre un moyen de comptage (4, DZ) pour compter le nombre de fois où des données sont stockées dans ledit moyen de mémoire non volatile (7) et un moyen d'affichage de comptage d'opérations de stockage (2, 4, 12) pour afficher le comptage d'opérations de stockage obtenu par ledit moyen de comptage (4, DZ).

6. Appareil selon la revendication 1, caractérisé en ce qu'il comprend en outre un circuit d'élément temporel (4, 13, 14) pour obtenir une information temporelle en comptant des signaux de référence et un moyen d'affichage de temps (2, 4, 12) pour afficher l'information temporelle obtenue par ledit circuit d'élément temporel (4, 13, 14).

7. Appareil selon la revendication 1, caractérisé en ce que ledit appareil de stockage de données est incorporé dans un boîtier d'un dispositif du type montre porté sur le poignet d'un utilisateur.

8. Appareil de stockage de données selon la revendication 1, comprenant en outre :
un moyen de comptage de date (104, 112, 113) pour obtenir des données de date courante en comptant des signaux de référence ;
un moyen de commande de stockage de date (104) pour forcer ledit moyen de mémoire non volatile (107) à stocker les données de date obtenues par ledit moyen de comptage de date (104, 112, 113) lorsque ladite alimentation par pile (109) est remplacée ;
un moyen de calcul de durée de vie de pile (104) pour obtenir des données de durée de vie de pile sur la base des données de date stockées dans ledit moyen de mémoire non volatile (107) par ledit moyen de commande de stockage de date (104, 112, 113) et des données de date courante obtenues par ledit moyen de comptage de date (104, 112, 113) ; et
un moyen d'affichage (102, 104, 111) pour afficher les données de durée de vie de pile obtenues par ledit moyen de calcul de durée de vie de pile (104).

9. Appareil selon la revendication 8, caractérisé en ce que ledit moyen de mémoire non volatile inclut une EEPROM (107).

10. Appareil selon la revendication 8, caractérisé en ce que les données de durée de vie de pile obtenues par ledit moyen de calcul de durée de vie de pile (104) sont le nombre de jours qui se sont écoulés depuis le dernier remplacement de la pile.

11. Appareil selon la revendication 8, caractérisé en ce que les données de durée de vie de pile obtenues par ledit moyen de calcul de durée de vie de pile (104) sont le nombre de jours restants jusqu'au remplacement suivant de la pile.

12. Appareil selon la revendication 8, caractérisé en ce qu'il comprend en outre un moyen d'indication pour indiquer que ledit moyen de détermination d'écriture (4, 104) détermine que les données sont écrites correctement dans ledit moyen de mémoire non volatile (7).

13. Appareil selon la revendication 8, caractérisé en ce qu'il comprend en outre un moyen de comptage (Z) pour compter le nombre de fois qu'un remplacement de pile est réalisé et un moyen d'affichage de comptage de remplacements de pile (102, 104, 111) pour afficher le nombre de fois compté par ledit moyen de comptage (Z).

14. Appareil selon la revendication 8, caractérisé en ce qu'il comprend en outre un circuit d'élément temporel (104, 112, 113) pour obtenir une information temporelle en comptant des signaux de référence et un moyen d'affichage de temps (102, 104, 111) pour afficher l'information temporelle obtenue par ledit circuit d'élément temporel (104, 112, 113).

15. Appareil selon la revendication 8, caractérisé en ce que ledit appareil de stockage de données est incorporé dans un boîtier d'un dispositif du type montre porté sur le poignet d'un utilisateur.

16. Appareil de stockage de données selon la revendication 1 ou 7, comprenant en outre :
un moyen de mémoire volatile (6) pour stocker les données entrées par ledit moyen d'entrée de données (3, 4, 103, 104) ;
un moyen de commutation de sélection (L, S3, 4) pour sélectionner le moyen parmi ledit moyen de mémoire volatile (6) et ledit moyen de mémoire non volatile (7) dans lequel les données entrées par ledit moyen d'entrée de données (3, 4) sont stockées ; et
un moyen de commande de stockage (4) pour forcer ledit moyen de mémoire non volatile (7) à stocker les données entrées par ledit moyen d'entrée de données (3, 4, 103, 104) lorsque ledit moyen de mémoire non volatile (7) est choisi par ledit moyen de commutation de sélection (L, S3, 4).

17. Appareil selon la revendication 16, caractérisé en ce que ledit moyen de mémoire volatile inclut une RAM (6).

18. Appareil selon la revendication 16, caractérisé en ce que ledit moyen d'information (2, 4, 12) comprend un premier moyen d'affichage pour afficher séquentiellement des données stockées dans ledit moyen de mémoire volatile (6) et un second moyen d'affichage pour afficher séquentiellement des données stockées dans ledit moyen de mémoire non volatile (7).

19. Appareil selon la revendication 16, caractérisé en ce qu'il comprend en outre un circuit d'alimentation (8) pour appliquer respectivement différentes tensions d'alimentation audit moyen de mémoire volatile (6) et audit moyen de mémoire non volatile (7) sur la base d'une tension de sortie provenant de ladite alimentation par pile (9).

20. Appareil selon la revendication 16, caractérisé en ce qu'il comprend en outre un moyen de comptage (DZ) pour compter le nombre de fois où les données sont stockées dans ledit moyen de mémoire non volatile (7) et en ce que ledit moyen d'information (2, 4, 12) affiche le comptage d'opérations de stockage obtenu par ledit moyen de comptage (DZ).

21. Appareil selon la revendication 16, caractérisé en ce qu'il comprend en outre un circuit d'élément temporel (4, 13, 14) pour obtenir une information temporelle en comptant des signaux de référence et en ce que ledit moyen d'information (2, 4, 12) affiche l'information temporelle obtenue par ledit circuit d'élément temporel (4, 13, 14).
